Europäisches Patentamt

European Patent Office

Office européen des brevets

(11) Publication number: **0 491 345 A2**

# EUROPEAN PATENT APPLICATION

(21) Application number: **91121577.0**

(22) Date of filing: **17.12.91**

(51) Int. Cl.5: **C04B 35/58**

(30) Priority: **19.12.90 JP 412203/90**

(43) Date of publication of application:
**24.06.92 Bulletin 92/26**

(84) Designated Contracting States:
**DE FR GB IT**

(71) Applicant: **Sumitomo Electric Industries, Ltd.**
**5-33, Kitahama 4-chome, Chuo-ku**
**Osaka 541(JP)**

(72) Inventor: **Yamakawa, Akira, c/o Itami Works of**
**Sumitomo Electric Ind., Ltd, 1-1, Koyakita**
**1-chome**
**Itami-shi, Hyogo(JP)**
Inventor: **Sogabe, Koichi, c/o Itami Works of**
**Sumitomo Electric Ind., Ltd, 1-1, Koyakita**
**1-chome**
**Itami-shi, Hyogo(JP)**

(74) Representative: **Patentanwälte Grünecker,**
**Kinkeldey, Stockmair & Partner**
**Maximilianstrasse 58**
**W-8000 München 22(DE)**

(54) **Silicon-nitride sintered body.**

(57) A silicon-nitride sintered body containing $Si_3N_4$ of not less than 90 weight %, aluminum atoms of not more than 3.5 weight %, oxygen atoms of not more than 3.5 weight %, and at least one kind of a metal element of 0.01 - 10 weight % selected from a group consisting of Ti, Zr, Hf, V, Nb, Ta, Cr, Mo, W, Mn, Fe, Co, Ni, Nd and Ho, the sintered body having a density of not less than 3.15 $g/cm^3$, and a heat conductivity of not less than 40 W/m·K.

## BACKGROUND OF THE INVENTION

The present invention relates to a silicon-nitride sintered body which is suitable for an electronic-circuit substrate material, and which has a high heat conductivity.

A sintered body of silicon-nitride ($Si_3N_4$) is superior in corrosion resistance and thermal resistance and has high strength so that it has been used as various kinds of high-temperature materials and also as materials for insulating substrates of electronic circuits such as ICs or the like by use of its high insulating property and chemical stability.

Particularly recently, trials of obtaining materials for insulating substrates having a high heat-conductivity have been actively carried out as the integration is made high and the capacity is made large with respect to semiconductor circuits, so that following BeO sintered bodies, AlN and SiC sintered bodies having a high heat-conductivity have been developed.

However, the AlN sintered body has a defect that hydroxide is formed in a high-temperature steam so that its insulating property is lowered. Also, the SiC sintered body has an essential problem that its dielectric constant is high. In the existing circumstances, any of the AlN and SiC sintered bodies is used only for limited use because of their demerits.

On the other hand, although an $Si_3N_4$ sintered body has high strength, it has been difficult to obtain an $Si_3N_4$ having a high heat-conductivity. That is, it is generally difficult to make $Si_3N_4$ dense, and in sintering at a high temperature there is a problem of decomposition and sublimation of $Si_3N_4$. Therefore, liquid phase sintering in which a sintering auxiliary agent is added has been conventionally performed. In the liquid-phase sintering, an agent in an $Al_2O_3$ group has been used as the sintering auxiliary agent so that a siaron compound is made in the point of view of attaching much importance to strength and resistance of oxidation at a high temperature. The main current of the study has not been directed to high purification. Further, it has been difficult to synthesize $Si_3N_4$ material powder having high purity. Accordingly, in the conventional $Si_3N_4$ sintered body, different kinds of atoms such as Al, O, or the like contained in the sintering auxiliary agent and the raw material powder are mixed to remain as a grain boundary or to be dissolved into $Si_3N_4$ lattices to make solid solution, so that it has been difficult to obtain material properties sufficiently showing the essential characteristics of $Si_3N_4$, and it has been general that the reported heat conductivity is about 15 W/m·K at the highest.

To this end, in Japanese Patent Unexamined Publication No. Sho. 62-30663, use of an $Si_3N_4$ sintered body for an electronic-circuit substrate has been proposed, but it is not put to practical use yet.

## SUMMARY OF THE INVENTION

In view of such conventional circumstances, it is an object of the present invention to provide an $Si_3N_4$ sintered body having a high heat-conductivity.

In order to attain the object, the silicon-nitride sintered body according to the present invention is characterized in that it contains $Si_3N_4$ of not less than 90 weight %, aluminum atoms of not more than 3.5 weight %, oxygen atoms of not more than 3.5 weight %, and at least one kind of a metal element of 0.01 - 10 weight % selected from a group consisting of Ti, Zr, Hf, V, Nb, Ta, Cr, Mo, W, Mn, Fe, Co, Ni, Nd and Ho, and it has a density of not less than 3.15 g/cm³, and a heat conductivity of not less than 40 W/m·K.

## DETAILED DESCRIPTION OF THE INVENTION

The inventors of the present invention considered that the reason why the heat conductivity of the conventional $Si_3N_4$ sintered body was low, was that the density of the sintered body was so low that scattering of phonon was caused by pores existing within the sintered body or that scattering of phonon was caused by different kinds of ions, particularly oxygen or aluminum, existing in a solid solution or remaining in a grain boundary. Accordingly, the inventors aimed to make the sintered body highly pure and dense and particularly to reduce the quantity of solid solution of oxygen and aluminum to thereby obtain, at last, the $Si_3N_4$ sintered body having a high heat-conductivity.

That is, it was found that the heat conductivity of the $Si_3N_4$ sintered body became a high value of not lower than 40 W/m·K when all the conditions that the content of $Si_3N_4$ is not less than 90 weight %, the content of each of the aluminum and oxygen atoms in difference kinds of atoms was not more than 3.5 weight %, and the density was not lower than 3.15 g/cm³, were satisfied at the same time.

It was found that the $Si_3N_4$ sintered body which was thus made to have a high purity and a high density, not only had a high heat-conductivity as described above but showed transparency. However, the transparency is an undesired property in the case where it is used for IC packages or the like in which light transmission is disliked.

In the $Si_3N_4$ sintered body according to the invention, at least one kind metal element selected from a group consisting of Ti, Zr, Hf, V, Nb, Ta, Cr, Mo, W, Mn, Fe, Co, Ni, Nd and Ho is added, so that light is prevented from being transmitted, while the heat conductivity is not lowered, to thereby give sufficient light-shielding property for an IC package or the like with the large absorption coefficient of not less than 60 cm$^{-1}$ for light having a wavelength of 4 $\mu$m. It is considered that each of such metal elements is made to be in the form of a nitride, a compound containing a lattice defect, or the like, in the sintered body so as to absorb or scatter light. When the content of the metal element is less than 0.01 weight %, light shielding by light absorption and scattering is insufficient. On the contrary, when the content of the metal element exceeds 10 weight %, the heat conductivity of the sintered body is lowered. Further, when a metal element other than the above-mentioned elements is added, the heat conductivity of the sintered body is lowered, or the light absorption and scattering are so insufficient that desirable light-shielding property can not be obtained.

In manufacturing the $Si_3N_4$ sintered body according to the present invention, it is necessary to strictly control the particle size and purity of $Si_3N_4$ powder to be used as a raw material. Specifically, the average particle-size of the $Si_3N_4$ powder is selected to be not larger than 2 $\mu$m, preferably to be within a range of from 0.1 $\mu$m to 1.0 $\mu$m. Further, the oxygen content in the $Si_3N_4$ powder should be not larger than 1.5 weight %, and the sum of the content of impurities of positive and negative ions of Al, O, C, etc. in solid solution should be not larger than 1.0 weight %. The highly-pure and fine $Si_3N_4$ powder can be synthesized through a reduction nitriding method, a method of nitriding a metal Si, a method of nitriding an organic $Si_3N_4$ compound, or a vapor-phase synthesizing method, and particularly it is preferable to synthesize the $Si_3N_4$ powder through a method of nitriding an Si-imide compound or a silane compound. Further, the above-mentioned metal element such as Ti or the like to be added for shielding light is preferably added in the form of an oxide, an organic metal compound, or the like.

After the $Si_3N_4$ powder is mixed with the light-shielding metal-compound powder, the mixed powder is sintered. The sintering method is not particularly limited and any method may be used so long as the sintered-body having a density of not less than 3.15 g/cm$^3$ can be obtained. The sintering auxiliary agent may be used or not. The sintering may be performed in the condition of ordinary pressure or pressurization. In the case where the sintering auxiliary agent is used, $Al_2O_3$ or the like which makes aluminum and oxygen be dissolved in solid solution is to be avoided, and $Y_2O_3$, $Sm_2O_3$, $Yb_2O_3$, CaO, etc. are to be used. Further, it is necessary to make the sintering temperature be 1500 - 2000 °C, and the sintering is performed in a non-oxidizing gas atmosphere containing $N_2$ in order to suppress the decomposition of $Si_3N_4$.

[Example]

The reduction nitriding method of the $SiO_2$ powder was employed and the mixture of impurities was strictly controlled, so that synthesized was $\beta$-type $Si_3N_4$ powder in which the oxygen content was 1.2 weight % and the quantity of impurities in solid solution was not more than 100 ppm, and in which the specific surface area (BET value) was 5.0 m$^2$/g (average particle size of about 0.3 $\mu$m). At least one kind selected from a group consisting of $TiO_2$, $ZrO_2$, $HfO_2$, $V_2O_5$, NbO, TaO, $Cr_2O_3$, Mo, W, MnO, Fe, Co, Ni, $Nd_2O_3$ and $Ho_2O_3$, of 0.5 weight % in terms of metal element, $Y_2O_3$ of 0.5 weight % as the sintering auxiliary agent, and phenol resin of 2.0 weight % were added to and mixed with the $Si_3N_4$ powder. Next, carbon molds on which BN powder was applied were filled with the mixed powder and the mixed powder in the carbon molds were sintered in a high frequency induction furnace under pressure of 200 Kg/cm$^2$ at a temperature of 2000 °C for 20 hours while an $N_2$ gas was being flown, so that $Si_3N_4$ sintered bodies each having a diameter of 15 mm and a thickness of 5 mm were manufactured.

Each of the obtained $Si_3N_4$ sintered bodies had a density of not less than 3.15 g/cm$^3$ and looked black apparently. After the $Si_3N_4$ sintered bodies were ground so as to have a thickness of 0.3 mm, both the surfaces of each of the $Si_3N_4$ sintered bodies were lapped and further polished with fine particle diamond abrasive grains to thereby prepare samples having a thickness of 0.2 mm. Each of the samples was semitransparent and had an absorption coefficient of not less than 100 cm$^{-1}$ (linear transmissivity of not more than 12 %) for light having a wavelength of 4 $\mu$m.

As a result of analysis of the thus obtained $Si_3N_4$ sinteredbodies, every sintered body contained oxygen of not more than 0.1 weight %, aluminum of not more than 10 ppm, and each of other positive and negative ion impurities of less than 10 ppm. Further, each of the sintered bodies was made to be in the form of a pellet having a thickness of 3 mm. The measured heat conductivity of every pellet was not less than 50 W/m·K.

According to the present invention, it is possible to provide an $Si_3N_3$ sintered body which has a heat-conductivity extremely higher than a conventional one and has a proper light-shielding property so that it is preferably used for an IC package or the like which dislikes light transmission.

**Claims**

1.   A silicon-nitride sintered body, comprising:

Si₃N₄ of not less than 90 weight %;

aluminum atoms of not more than 3.5 weight %;

oxygen atoms of not more than 3.5 weight %; and

at least one kind of a metal element of 0.01 - 10 weight % selected from a group consisting of Ti, Zr, Hf, V, Nb, Ta, Cr, Mo, W, Mn, Fe, Co, Ni, Nd and Ho;

wherein said sintered body has a density of not less than 3.15 g/cm³, and a heat conductivity of not less than 40 W/m·K.

2.   A silicon-nitride sintered body according to claim 1, wherein an absorption coefficient for light having a wavelength of 4 μm is not less than 60 cm⁻¹.